# FASCICULE DE BREVET EUROPEEN

(11) **EP 2 120 270 B1**
(45) Date de publication et mention de la délivrance du brevet: **29.03.2017**
(21) Numéro de dépôt: 09354019.3
(22) Date de dépôt: 14.05.2009
(51) Int. Cl.: H01L 31/18, H01L 31/072

(54) **Film autosupporté et plaquette en silicium obtenue par frittage**
Selbsttragende Folie und durch Sinterverfahren hergestelltes Siliziumplättchen
Self-supported film and silicon plate obtained by sintering

(30) Priorité: 16.05.2008 FR 0802650
(43) Date de publication de la demande: 18.11.2009
(73) Titulaire: Commissariat à l'Énergie Atomique et aux Énergies Alternatives, 75015 Paris (FR)
(72) Inventeur: Garandet, Jean-Paul, 73370 Le Bourget du Lac (FR); Drevet, Béatrice, 38000 Grenoble (FR); Federzoni, Luc, 38300 Bourgoin-Jallieu (FR)
(74) Mandataire: Hecké, Gérard

(56) Documents cités:
- US-A- 5 800 611
- US-A1- 2004 082 098
- US-A1- 2004 126 582
- US-A1- 2007 014 682

## Description

### Domaine technique de l'invention

L'invention concerne un film autosupporté ainsi qu'un procédé de réalisation d'au moins une plaquette en silicium pour cellule photovoltaïque.

### État de la technique

Actuellement, les cellules photovoltaïques sont majoritairement fabriquées à partir de silicium monocristallin ou de silicium polycristallin.

Le silicium utilisé dans les applications photovoltaïques peut être obtenu par un procédé par voie liquide, c'est-à-dire à partir d'un bain de silicium fondu. Une fois le silicium solidifié, par exemple sous forme d'un lingot ou d'un film, il est ensuite découpé en plaquettes d'une épaisseur comprise entre 100µm et 500µm. Puis, les plaquettes sont transformées en cellules photovoltaïques. Cependant, cette étape de découpe est préjudiciable car elle se traduit par une perte de matière.

Pour pallier cet inconvénient, plusieurs techniques d'élaboration en plaquettes ou en rubans ont été développées ces dernières années.

À titre d'exemple, des tubes octogonaux de silicium peuvent être réalisés par un procédé de croissance de silicium en ruban également appelé « EFG », consistant à faire remonter du silicium fondu dans un conduit capillaire et à le mettre en contact avec un germe se déplaçant verticalement. Comme rapporté par B. Mackintosh et al., dans l'article « Large silicon crystal hollow-tube growth by the edge-defined film-fed growth (EFG) method » (Journal of Crystal Growth (2006) 428-432), la vitesse de tirage, limitée par les contraintes thermomécaniques générées dans le ruban, se situe entre 1,5cm/min et 1,8 cm/min.

Une autre technique, appelée procédé RAD (« Ribbon Against Drop ») et décrite dans *l'article* « Growth of silicon ribbons by the RAD process » de C. Belouet (Journal of Crystal Growth 82 (1987) 110-116), consiste à réaliser le tirage sur un substrat étranger dit « chaud ». Un tel substrat est par exemple une feuille de graphite souple. La feuille traverse verticalement le bain de silicium fondu afin d'être, à la sortie du bain de silicium, revêtue de silicium sur ses deux faces. Dans ce cas, la valeur maximale de la vitesse de solidification est la valeur seuil au-delà de laquelle on passe en mode de croissance dendritique, tandis que la valeur minimale est imposée par l'épaisseur visée pour le ruban de silicium. Par exemple, une vitesse de 10 cm/min permet de réaliser des rubans de 80 µm d'épaisseur et la largeur des rubans est limitée à des valeurs de l'ordre de 10 cm.

Des vitesses de tirage plus élevées (environ 10 m/min) peuvent être obtenues avec des procédés de tirage sur un support étranger dit « froid », tel que le procédé de tirage horizontal, également appelé RGS (« Ribbon Growth on Substrate ») et mentionné dans le brevet US4670096. Dans le procédé de type RGS, un support en mouvement entre en contact avec un bain liquide et ressort en entraînant un film de silicium sur l'une de ses faces. La chaleur est extraite par conduction dans le substrat froid. Il en résulte une solidification, s'initiant à partir du substrat et générant une structure à petits grains orientés suivant l'épaisseur du ruban (d'environ 500 µm) et peu adaptée aux applications dans le domaine photovoltaïque. La largeur des rubans étant voisine de 15 cm, le rendement est ainsi d'environ 240 cm² de surface de plaques par seconde.

Au lieu d'employer des procédés de fabrication par défilement, certains ont proposé d'utiliser une technique de moulage, afin de permettre la réalisation simultanée d'un grand nombre de plaques de silicium. Ainsi, la technique de moulage est, par exemple, décrite dans la demande de brevet JP-A-4292494 déposée par UNION MATERIAL KK en 1992. Le moule est constitué d'un empilement de pièces élémentaires évidées permettant de réaliser plusieurs plaquettes de silicium en parallèle. L'infiltration du silicium liquide dans le moule se fait soit par une force extérieure (par exemple un piston) soit par écoulement naturel. Le silicium est ensuite solidifié, dans une gamme de vitesse de 0,02 à 0,5 cm/min.

Par ailleurs, la demande de brevet WO-A-2004/093202 propose une technique tout à faite différente pour réaliser une plaquette de silicium. Celle-ci est réalisée par pressage, de préférence à chaud, d'un lit de poudres disposé entre deux plateaux et par traitement thermique afin qu'une partie des poudres soit fondue ou rendue visqueuse. Un tel procédé présente l'avantage de pouvoir contrôler la géométrie, la rugosité et/ou l'état de surface des plaquettes formées après pressage et frittage. Cependant, actuellement, un tel procédé ne permet pas d'atteindre des rendements de conversion énergétiques élevés.

Dans la demande de brevet US2007/014682, un procédé propose de compacter et densifier une poudre de silicium de haute pureté en des formes géométriques définies ayant une pureté proche de celle de la poudre de silicium initiale, afin, par exemple, d'être utilisées dans l'industrie photovoltaïque basée sur le silicium. La poudre de silicium est, en particulier, mélangée à un liant sélectionné. Le mélange est ensuite séché et compressé en des formes souhaitées, avant que la réalisation d'opérations de déliantage et de frittage. Le liant est choisi parmi des liants à base de silicium (fumée de silice de haute pureté, silice colloïdale de haute pureté ou polyakloxysilanes), et des liants à base de carbone (polyalkylènes carbonates, acide stéarique ou stéarate de zinc).

Dans la demande de brevet US5800611, une feuille de silicium monocristalline est obtenue à partir d'une feuille polycristalline réalisée en étendant sur une surface un coulis composé d'une poudre de silicium, d'un liant et d'un solvant. Ceci permet d'obtenir la feuille après évaporation du solvant. Le liant est, par la suite, éliminé par chauffage.

### Objet de l'invention

L'invention a pour but de proposer un procédé de fabrication d'au moins une plaquette en silicium, utilisée dans le domaine photovoltaïque, remédiant aux inconvénients de l'art antérieur et plus particulièrement aux inconvénients des procédés de fabrication par pressage et frittage de particules de silicium.

Selon l'invention, ce but est atteint par les revendications annexées.

En particulier, ce but est atteint par un film autosupporté comportant au moins une couche mince principale comprenant au moins 50% en volume de particules de silicium, exemptes d'oxyde de silicium et encapsulées dans une matrice polymère protégeant les particules de silicium contre l'oxydation, ladite matrice polymère comportant au moins un polymère protecteur contre l'oxydation ne contenant pas d'oxygène.

Ce but est également atteint par un procédé de fabrication d'au moins une plaquette en silicium comportant une étape de déliantage d'un tel film autosupporté suivie d'une étape de frittage pour former la plaquette en silicium. De plus, selon un développement de l'invention, l'étape de déliantage est précédée d'une étape de formation dudit film autosupporté comprenant au moins la réalisation de la couche mince principale par extrusion d'un mélange comprenant au moins les particules de silicium exemptes d'oxyde de silicium et des granules d'au moins un polymère protecteur contre l'oxydation et ne contenant pas d'oxygène ou d'au moins un précurseur dudit polymère.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 6 représentent, schématiquement et en coupe, différentes étapes d'un procédé de fabrication d'une plaquette en silicium selon l'invention.
- les figures 7 et 8, représentent schématiquement en coupe, deux variantes de réalisation dans un procédé de fabrication d'une plaquette en silicium selon l'invention.

### Description de modes particuliers de réalisation

Au moins une plaquette en silicium, utilisée dans la fabrication d'une cellule photovoltaïque, est réalisée par frittage de particules de silicium. La plaquette en silicium est réalisée à partir d'un film autosupporté, également appelé film autoportant, c'est-à-dire un film manipulable sans l'aide de support. Le film autosupporté est formé d'au moins une couche mince principale comprenant au moins 50% en volume de particules de silicium, exemptes d'oxyde de silicium et encapsulées dans une matrice polymère les protégeant contre l'oxydation.

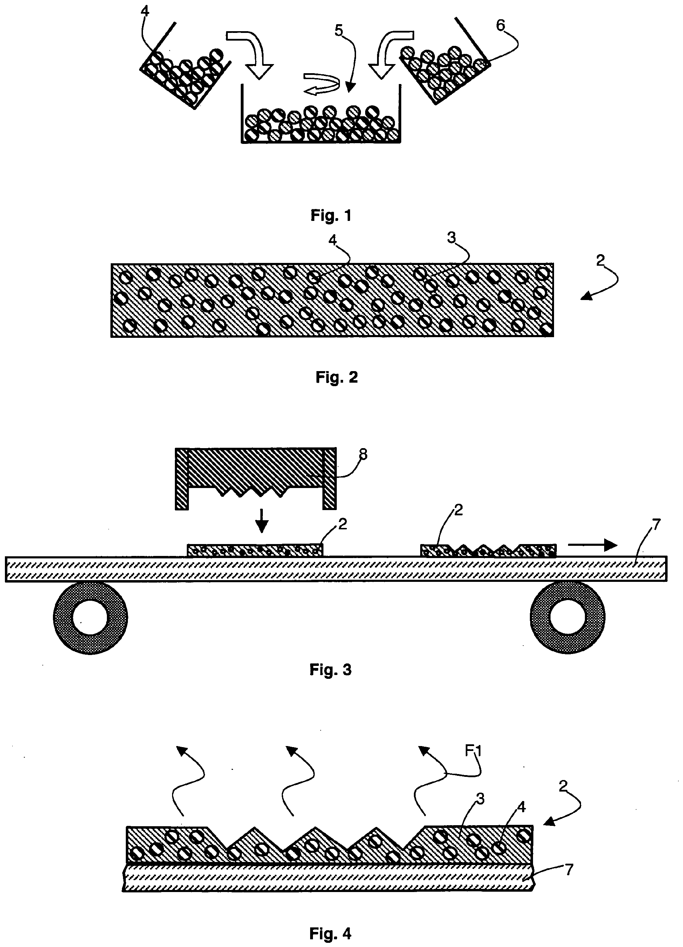

À titre d'exemple et comme représenté sur les figures 1 à 6, une plaquette en silicium 1 est, en particulier, réalisée à partir d'un film autosupporté 2 tel que représenté sur la figure 2.

Le film autosupporté 2 est, sur la figure 2, constitué par une couche mince unique formée d'une matrice polymère 3 dans laquelle sont dispersées des particules de silicium 4.

Les particules de silicium 4 peuvent, par exemple, être des particules de dimensions micrométriques et/ou de dimensions nanométriques. En particulier, des particules de silicium de dimensions micrométriques ont avantageusement un diamètre moyen compris entre 10µm et 100µm, tandis que des particules de dimensions nanométriques ont avantageusement un diamètre moyen compris entre 10nm et 100nm. L'utilisation de particules de silicium ayant des dimensions nanométriques ou d'un mélange de particules de dimensions micrométriques et de particules de dimensions nanométriques permet, en particulier, de réduire la température de frittage sans avoir recours à des agents fondants. De plus, une réduction de la température de frittage permet un meilleur contrôle de l'homogénéité du frittage et une limitation du risque de pollution additionnel. Enfin, l'utilisation de particules de silicium fines permet d'obtenir une plaquette en silicium ayant une surface structurée plus fine, ce qui améliore le piégeage de la lumière dans les cellules photovoltaïques.

Les particules de silicium 4 sont, de préférence, nettoyées avant d'être encapsulées dans la matrice polymère 3, afin d'enlever la couche d'oxyde de silicium natif présente à la surface des particules 4. En effet, même à température ambiante, le silicium se recouvre d'une couche d'oxyde « natif » d'une épaisseur de quelques nanomètres dès qu'il est en présence d'oxygène. Or, plus les particules sont petites, plus la présence d'une couche d'oxyde de silicium natif est néfaste. Ainsi, pour des particules de taille nanométrique, la fraction volumique d'oxygène peut facilement atteindre 10%, ce qui peut rendre le matériau impropre à la réalisation de cellules photovoltaïques. Le nettoyage des particules de silicium 4 peut, par exemple, être réalisé dans une atmosphère inerte, par attaque à l'acide fluorhydrique.

Le nettoyage des particules est suivi de la formation du film autosupporté 2 comprenant au moins les particules de silicium réparties dans la matrice polymère protectrice 3. L'épaisseur du film 2 peut être ajustable. Elle peut, par exemple, être comprise entre 100µm et 1 mm. De plus, la couche mince formant le film autosupporté 2 comporte au moins 50% en volume de particules de silicium et, avantageusement, entre 70% et 85%. À titre d'exemple, le taux de charge volumique en particules de silicium dans le mélange est, par exemple, de l'ordre de 80%. La matrice polymère 6 comporte au moins un polymère destiné à protéger les particules 4 contre l'oxydation. Un tel polymère protecteur est, en particulier, un polymère ne contenant pas d'oxygène. Avantageusement, il est choisi parmi les polymères obtenus à partir d'un ou plusieurs monomères de type alcènes. Il est plus particulièrement choisi parmi le polyéthylène et le polypropylène.

En particulier et comme représenté sur la figure 1, le film autosupporté 2 peut être formé par extrusion d'un mélange 5 comprenant au moins les particules de silicium 4 et des granules 6 d'au moins un polymère protecteur contre l'oxydation et ne contenant pas l'élément chimique oxygène. Les granules 6 peuvent également être des granules d'au moins un précurseur dudit polymère. Le mélange 5 peut également contenir un agent dispersant, tel que l'acide stéarique (environ 2% en volume), afin d'éviter une agglomération des particules de silicium 4 au sein de la matrice polymère 3. De plus, selon leur taille, les particules de silicium peuvent subir, avant leur mélange avec les granules 6, une étape de granulation qui leur confère des propriétés rhéologiques adaptées.

Le film 2 obtenu par extrusion présente l'avantage d'être autoportant. Il peut, ainsi, être déroulé au défilé sur un support 7. Le support 7 est, par exemple, un tapis en graphite revêtu d'une couche de nitrure de silicium, ce qui permet d'éviter le collage de la plaquette 1 après l'étape de frittage.

Puis, comme représenté sur la figure 3, le film autosupporté 2, disposé sur le support 7, peut être découpé à l'aide d'un outil de coupe 8 permettant d'obtenir un film 2 ayant des dimensions et une forme déterminées en fonction des dimensions et de la forme souhaitées pour la plaquette en silicium 1 réalisée après le frittage. Plus particulièrement, l'opération de découpe doit tenir compte des réductions dimensionnelles s'opérant lors des étapes ultérieures. La surface de l'outil de coupe 8 venant en contact avec la surface libre du film 2 peut, avoir une forme particulière destinée à structurer la surface libre du film 2. Les réductions dimensionnelles ultérieures sont également prises en contact lors de la structuration de la surface libre du film 2.

Pour réaliser la plaquette en silicium 1, le film autosupporté 2 est délianté. En particulier, le polymère formant la matrice 3 est éliminé par traitement thermique, à une température comprise entre environ 300°C et environ 500°C. La température est, par exemple, de l'ordre de 450°C pour une matrice en polypropylène ou en polyéthylène. À titre d'exemple, pour un film de 300µm d'épaisseur en polypropylène et comprenant 80% de particules de silicium d'un diamètre moyen de 1µm, l'opération de déliantage est réalisée dans un four résistif pendant 24 heures, à 450°C, sous balayage d'hydrogène afin d'évacuer les résidus de déliantage.

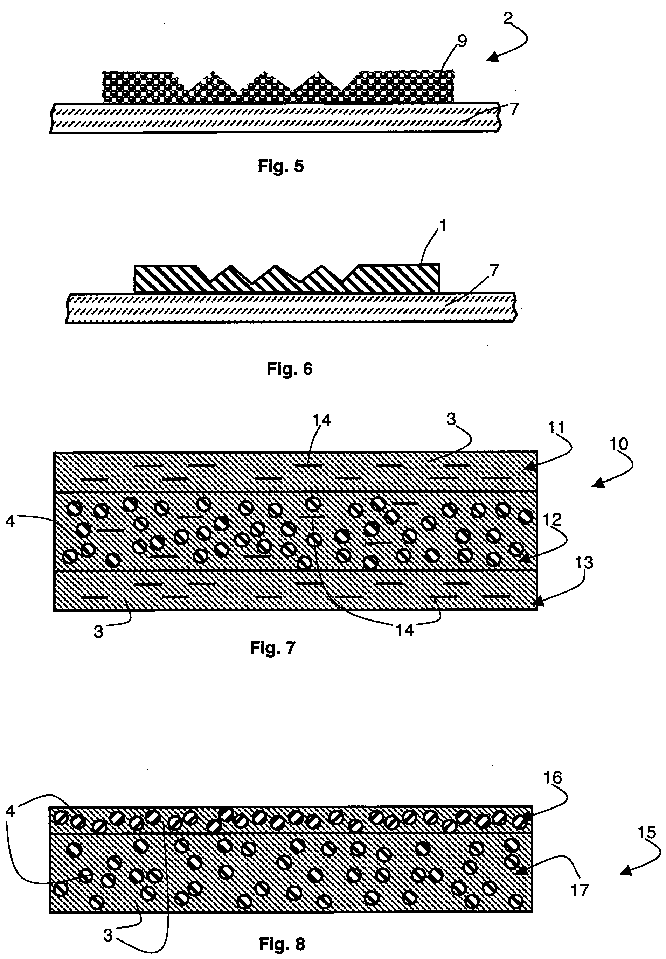

Ainsi, comme illustré sur les figures 4 et 5, le déliantage du film 2 (flèches F1) permet d'éliminer le matériau encapsulant les particules de silicium 2, c'est-à-dire la matrice 3. Ainsi, l'opération de déliantage permet de transformer le film autosupporté 2 en un lit 9 de particules de silicium, ne contenant pas de polymère. Le lit 9 présente, de plus, une forme sensiblement identique à celle du film autosupporté 2, les dimensions du lit 9 étant, cependant, légèrement réduites par rapport à celles du film 2. Cette réduction dépend du taux de particules de silicium.

Une fois le film 2 délianté, le lit 9 subit une étape de frittage pour former une plaquette 1 formée de silicium le plus dense possible. Le frittage permet, en effet, de lier les particules de silicium entre elles et donc d'obtenir une plaquette en silicium dense. Il permet, avantageusement, selon la taille des particules de silicium et selon la température de frittage, d'obtenir une fusion d'une partie des particules. L'étape de frittage est, avantageusement, réalisée à une température comprise entre environ 1000°C et environ 1300°C selon la taille initiale des particules de silicium et la porosité souhaitée. De plus, l'étape de frittage est, avantageusement, réalisée dans un four à passage. En général, le frittage est réalisé dans le même four que celui utilisé lors de l'étape de déliantage, afin de ne pas avoir à manipuler le lit 9, qui est très fragile. À titre d'exemple, l'étape de frittage peut être réalisée, par exemple, pendant 4 heures, à une température de 1300°C et sous atmosphère d'hydrogène pour permettre une hydrogénation à coeur dans les particules de silicium et donc une passivation des défauts, qui sont, en général, un facteur limitant pour l'efficacité énergétique d'une cellule photovoltaïque.

Comme représentée sur la figure 6, la plaquette en silicium 1 présente des dimensions réduites par rapport à celles du lit 9 représenté sur la figure 5 et à celles du film autosupporté 2 représenté sur la figure 4.

Une telle plaquette en silicium 1 est prête à l'usage et elle peut être utilisée pour réaliser une cellule photovoltaïque.

Le procédé de réalisation d'une telle plaquette en silicium présente, en particulier, l'avantage de permettre la réalisation de cellules photovoltaïques pouvant atteindre des rendements de conversion énergétiques plus élevés (supérieurs à 10%) que ceux obtenus avec un procédé de fabrication selon l'art antérieur tel que décrit dans la demande de brevet WO-A-2004/093202. En effet, le fait d'encapsuler des particules de silicium exemptes d'oxyde de silicium dans une matrice protectrice constituée d'un polymère sans oxygène protège les particules de l'oxydation et améliore donc les rendements de conversions énergétiques des cellules photovoltaïques. De plus, avant que la plaquette de silicium 1 ne soit réalisée par frittage, le film autosupporté 2 peut être stocké pendant un certain temps, sans précaution particulière pour éviter l'oxydation des particules. Il est également plus aisé de manipuler les particules de silicium lorsque celles-ci sont encapsulées dans un film autosupporté que lorsqu'elles sont en vrac. En effet, la mise en oeuvre des particules de silicium sous forme d'un film autosupporté permet de manipuler des poudres à haute surface développée sans risque d'oxydation. Par ailleurs, la réalisation d'une plaquette en silicium en utilisant un film autosupporté comprenant des particules de silicium, exemptes d'oxyde natif et encapsulées dans une matrice polymère protectrice, permet également d'éviter des pertes de matière liée aux opérations de découpe des lingots ou des rubans dans les procédés de fabrication par voie liquide.

Enfin, l'emploi d'au moins un polymère et éventuellement d'un agent dispersant comportant de l'hydrogène améliore l'hydrogénation des particules de silicium par rapport aux procédés de fabrication selon l'art antérieur. En effet, avec ces procédés selon l'art antérieur, l'hydrogène n'est introduit qu'au moment de la réalisation des couches antireflets des cellules photovoltaïques au-dessus de l'émetteur, ce qui limite sa diffusion au coeur du matériau de ladite cellule. Pour parfaire la désoxygénation des particules, l'étape de déliantage peut être réalisée sous vide et un flash d'hydrogène peut être appliqué lors de l'étape de frittage.

Selon une variante de réalisation, la matrice polymère protectrice 3 utilisée pour le film autosupporté peut également contenir des charges additionnelles autres que les particules de silicium. Ces charges additionnelles peuvent, par exemple, être des particules minérales, telles que des argiles, ayant pour effet de piéger l'oxygène et la vapeur d'eau ou bien des nanotubes de carbone. Avantageusement, ces charges additionnelles sont des charges de dimensions nanométriques. Ceci est particulièrement avantageux pour renforcer les propriétés de protection et/ou barrière de la matrice polymère 3 vis-à-vis de l'eau et de l'oxygène, notamment lorsque les durées et/ou l'environnement de stockage sont contraignants. Lorsque les particules minérales sont des nanotubes de carbone, ces particules sont éliminées lors de l'étape de déliantage en même temps que la matrice 3, contrairement aux argiles.

De plus, le film autosupporté 2 peut comporter plus d'une couche mince. Ainsi, le film autosupporté peut être constitué d'un empilement de plusieurs couches superposées. La ou les couche(s) mince(s) contenant des particules de silicium 4 est(sont) appelée(s) couche(s) mince(s) principale(s).

En particulier, par exemple dans le cas de particules de silicium 4 très fines, le film peut comporter une couche mince principale disposée entre deux couches protectrices, chacune étant formée par la matrice polymère 3 sans les particules de silicium 4. Par ailleurs, les couches protectrices peuvent également comporter des charges additionnelles, telles que des charges minérales. À titre d'exemple, sur la figure 7, un film autosupporté 10 est formé de trois couches superposées 11, 12 et 13. La couche 12 est une couche mince principale, comportant une matrice polymère protectrice 3 dans laquelle sont réparties uniformément des particules de silicium 4 et des charges additionnelles 14. La couche mince principale 12 est disposée entre les deux couches protectrices 11 et 13 comprenant chacune la matrice polymère protectrice 3 et les charges additionnelles 14.

Par ailleurs, chaque couche mince principale peut comporter des éléments dopant de type n ou de type p. Les éléments dopants sont, en général, ajoutés au silicium 4 lors de la réalisation des particules de silicium, avant le mélange desdites particules avec les granules de polymère 6. Ainsi, sur la figure 8, un film autosupporté 15 comporte deux couches minces principales superposées 16 et 17 comportant chacune des particules de silicium dopé respectivement de type n et de type p. Dans ce cas, la couche mince 16 en silicium dopé de type n est beaucoup plus fine que la couche mince 17 en silicium dopé de type p. L'épaisseur de la couche 16 est par exemple de 2µm pour une couche 17 ayant une épaisseur de 300µm. Une couche mince 16 aussi fine serait difficilement obtenue par des procédés classiques d'extrusion. Elle serait par exemple réalisée par enduction ou par trempage de la couche mince 17, réalisée elle-même par extrusion.

Ainsi, selon l'invention, la superposition de couches minces principales contenant des matériaux de types ou de niveaux de dopage différents permet, en particulier, de réaliser des plaquettes en silicium multicouches de manière plus contrôlée que dans le procédé décrit dans la demande de brevet WO-A-2004/0933202. En effet, dans le procédé décrit dans la demande de brevet WO-A-2004/0933202, un mélange des éléments dopants sous l'effet des contraintes mécaniques est inévitable au moment de l'étape de pressage.

## Revendications

1. Film autosupporté (2, 10, 15) **caractérisé en ce qu'**il comporte au moins une couche mince principale (12, 16, 17) comprenant au moins 50% en volume de particules de silicium (4), exemptes d'oxyde de silicium et encapsulées dans une matrice polymère (3) protégeant les particules de silicium (4) contre l'oxydation, ladite matrice polymère (3) étant constitué d'un ou plusieurs polymères protecteurs contre l'oxydation, ne contenant pas d'oxygène.

2. Film (2, 10, 15) selon la revendication 1, **caractérisé en ce que** la couche mince principale comporte entre 70% et 85% en volume de particules de silicium (4).

3. Film (2, 10, 15) selon l'une des revendications 1 et 2, **caractérisé en ce que** le polymère est formé à partir d'au moins un monomère de type alcène.

4. Film (2, 10, 15) selon la revendication 3, caractérisé en que le polymère est choisi parmi le polyéthylène et le polypropylène.

5. Film (2, 10, 15) selon l'une quelconque des revendications 1 à 4, **caractérisé en ce qu'**au moins une partie des particules de silicium (4) a un diamètre moyen compris entre 10µm et 100µm.

6. Film (2, 10, 15) selon l'une quelconque des revendications 1 à 5, **caractérisé en ce qu'**au moins une partie des particules de silicium (4) a un diamètre moyen compris entre 10nm et 100nm.

7. Film (2, 10, 15) selon l'une quelconque des revendications 1 à 6, **caractérisé en ce que** la couche mince principale (12, 16, 17) comporte des éléments dopant de type n ou de type p.

8. Film (15) selon l'une quelconque des revendications 1 à 7, **caractérisé en ce qu'**il comporte au moins deux couches minces principales superposées (16, 17) comportant chacune des particules de silicium dopé respectivement de type n et de type p.

9. Film (10) selon l'une quelconque des revendications 1 à 8, **caractérisé en ce qu'**il comporte deux couches protectrices (11, 13) comprenant chacune au moins la matrice polymère et entre lesquelles est au moins disposée la couche mince principale (12).

10. Procédé de réalisation d'au moins une plaquette en silicium (1) pour cellule photovoltaïque, **caractérisé en ce que** le procédé comporte une étape de déliantage d'un film autosupporté (2, 10, 15) selon l'une quelconque des revendications 1 à 9, suivie d'une étape de frittage pour former la plaquette en silicium (1).

11. Procédé selon la revendication 10, **caractérisé en ce que** l'étape de déliantage est précédée d'une étape de formation dudit film autosupporté (2, 10, 15) comprenant au moins la réalisation de la couche mince principale (12, 16, 17) par extrusion d'un mélange (5) comprenant au moins les particules de silicium (4) exemptes d'oxyde de silicium et des granules (6) d'au moins un polymère protecteur contre l'oxydation ou d'au moins un précurseur dudit polymère.

12. Procédé selon l'une des revendications 10 et 11, **caractérisé en ce que** le mélange (5) comporte un agent dispersant.

13. Procédé selon l'une quelconque des revendications 10 à 12, **caractérisé en ce que** le mélange (5) comporte des particules minérales absorbant l'eau et l'oxygène.

14. Procédé selon la revendication 13, **caractérisé en ce que** les particules minérales sont choisies parmi les argiles et les nanotubes de carbone.

15. Procédé selon l'une quelconque des revendications 10 à 14, **caractérisé en ce que** la surface des particules de silicium (4) est nettoyée à l'aide d'acide fluorhydrique, avant la formation de la couche mince principale (12, 16, 17).

16. Procédé selon l'une quelconque des revendications 10 à 15, **caractérisé en ce que** l'étape de déliantage du film autosupporté (2, 10, 15) est réalisée par traitement thermique à une température comprise entre environ 300°C et environ 500°C.

17. Procédé selon l'une quelconque des revendications 10 à 16, **caractérisé en ce que** l'étape de frittage est réalisée par traitement thermique à une température comprise entre environ 1000°C et environ 1300°C.

18. Procédé selon l'une quelconque des revendications 10 à 17, **caractérisé en ce que** l'étape de frittage est réalisée sous atmosphère d'hydrogène

## Patentansprüche

1. Selbsttragende Folie (2, 10, 15), **dadurch gekennzeichnet, dass** sie wenigstens eine dünne Hauptschicht (12, 16, 17) umfasst, die wenigstens 50 Vol.-% Siliziumpartikel (4), welche frei von Siliziumoxid und in eine die Siliziumpartikel (4) vor Oxidation schützende Polymermatrix (3) eingekapselt sind, umfasst, wobei die Polymermatrix (3) von einem oder mehreren vor Oxidation schützenden Polymeren, die keinen Sauerstoff enthalten, gebildet ist.

2. Folie (2, 10, 15) nach Anspruch 1, **dadurch gekennzeichnet, dass** die dünne Hauptschicht zwischen 70 und 85 Vol.-% Siliziumpartikel (4) umfasst.

3. Folie (2, 10, 15) nach einem der Ansprüche 1 und 2, **dadurch gekennzeichnet, dass** das Polymer aus wenigstens einem Monomer vom Typ Alken gebildet ist.

4. Folie (2, 10, 15) nach Anspruch 3, **dadurch gekennzeichnet, dass** das Polymer aus Polyethylen und Polypropylen ausgewählt ist.

5. Folie (2, 10, 15) nach einem der Ansprüche 1 bis 4, **dadurch gekennzeichnet, dass** wenigstens ein Teil der Siliziumpartikel (4) einen mittleren Durchmesser zwischen 10 µm und 100 µm aufweist.

6. Folie (2, 10, 15) nach einem der Ansprüche 1 bis 5, **dadurch gekennzeichnet, dass** wenigstens ein Teil der Siliziumpartikel (4) einen mittleren Durchmesser zwischen 10 nm und 100 nm aufweist.

7. Folie (2, 10, 15) nach einem der Ansprüche 1 bis 6, **dadurch gekennzeichnet, dass** die dünne Hauptschicht (12, 16, 17) Dotierungselemente vom n-Typ oder vom p-Typ umfasst.

8. Folie (15) nach einem der Ansprüche 1 bis 7, **dadurch gekennzeichnet, dass** sie wenigstens zwei übereinander angeordnete dünne Hauptschichten (16, 17) umfasst, die jeweils n-Typ- bzw. p-Typ-dotierte Siliziumpartikel umfassen.

9. Folie (10) nach einem der Ansprüche 1 bis 8, **dadurch gekennzeichnet, dass** sie zwei Schutzschichten (11, 13) umfasst, die jeweils wenigstens die Polymermatrix umfassen und zwischen denen wenigstens die dünne Hauptschicht (12) angeordnet ist.

10. Verfahren zur Herstellung wenigstens eines Siliziumplättchens (1) für eine Photovoltaikzelle, **dadurch gekennzeichnet, dass** das Verfahren einen Schritt zur Entbinderung einer selbsttragenden Folie (2, 10, 15) nach einem der Ansprüche 1 bis 9 umfasst, an den sich ein Sinterschritt anschließt, um das Siliziumplättchen (1) zu bilden.

11. Verfahren nach Anspruch 10, **dadurch gekennzeichnet, dass** dem Entbinderungsschritt ein Schritt zur Bildung der selbsttragenden Folie (2, 10, 15) vorangeht, umfassend wenigstens die Ausbildung der dünnen Hauptschicht (12, 16, 17) durch Extrudieren einer Mischung (5), die wenigstens die siliziumoxidfreien Siliziumpartikel (4) und Körnchen (6) aus wenigstens einem vor Oxidation schützenden Polymer oder aus wenigstens einem Vorläufer des Polymers umfasst.

12. Verfahren nach einem der Ansprüche 10 und 11, **dadurch gekennzeichnet, dass** die Mischung (5) ein Dispersionsmittel umfasst.

13. Verfahren nach einem der Ansprüche 10 bis 12, **dadurch gekennzeichnet, dass** die Mischung (5) mineralische Teilchen, die Wasser und Sauerstoff aufnehmen, umfasst.

14. Verfahren nach Anspruch 13, **dadurch gekennzeichnet, dass** die mineralischen Teilchen aus Ton und Kohlenstoffnanoröhren ausgewählt sind.

15. Verfahren nach einem der Ansprüche 10 bis 14, **dadurch gekennzeichnet, dass** die Oberfläche der Siliziumpartikel (4) vor der Bildung der dünnen Hauptschicht (12, 16, 17) mit Hilfe von Fluorwasserstoffsäure gereinigt wird.

16. Verfahren nach einem der Ansprüche 10 bis 15, **dadurch gekennzeichnet, dass** der Schritt der Entbinderung der selbsttragenden Folie (2, 10, 15) durch Wärmebehandlung bei einer Temperatur zwischen etwa 300 °C und etwa 500 °C durchgeführt wird.

17. Verfahren nach einem der Ansprüche 10 bis 16, **dadurch gekennzeichnet, dass** der Sinterschritt durch Wärmebehandlung bei einer Temperatur zwischen etwa 1000 °C und etwa 1300 °C durchgeführt wird.

18. Verfahren nach einem der Ansprüche 10 bis 17, **dadurch gekennzeichnet, dass** der Sinterschritt unter Wasserstoffatmosphäre durchgeführt wird.

## Claims

1. A self-supported film (2, 10, 15), **characterised in that** it includes at least a main thin layer (12, 16, 17) comprising at least 50% volume of silicon particles (4) devoid of silicon oxide and encapsulated in a polymer matrix (3) protecting the silicon particles (4) against oxidation, the polymer matrix (3) being formed of one or several oxygen-free polymer protecting against oxidation.

2. The film (2, 10, 15) according to claim 1, **characterised in that** the main thin layer comprises between 70% and 85% volume of silicon particles.

3. The film (2, 10, 15) according to one of claims 1 and 2, **characterised in that** the polymer is formed from at least an alkene monomer.

4. The film (2, 10, 15) according to claim 3, **characterised in that** the polymer is selected from polyethylene and polypropylene.

5. The film (2, 10, 15) according to any one of claims 1 to 4, **characterised in that** at least a part of the silicon particles (4) has a mean diameter comprised between 10µm and 100µm.

6. The film (2, 10, 15) according to any one of claims 1 to 5, **characterised in that** at least a part of the silicon particles (4) has a mean diameter comprised between 10nm and 100nm.

7. The film (2, 10, 15) according to any one of claims 1 to 6, **characterised in that** the main thin layer (12, 16, 17) comprises n-type or p-type doping elements.

8. The film (15) according to any one of claims 1 to 7, **characterised in that** it comprises at least two superposed main thin layers (16, 17) each comprising respectively n-doped and p-doped silicon particles.

9. The film (10) according to any one of claims 1 to 8, **characterised in that** it comprises two protective layers (11, 13) each comprising at least the polymer matrix and between which at least the main thin layer (12) is arranged.

10. A method for producing at least one silicon wafer (1) for a photovoltaic cell, **characterised in that** the method comprises a debinding step of the self-supported film (2, 10, 15) according to any one of claims 1 to 9, followed by a sintering step so as to form the silicon wafer (1).

11. The method according to claim 10, **characterised in that** the debinding step is preceded by forming the self-supported film (2, 10, 15), comprising at least production of the main thin layer (12, 16, 17) by extrusion of a mixture (5) comprising at least the silicon particles (4) devoid of silicon oxide and granules (6) of at least one polymer protecting against oxidation or of at least one precursor of said polymer.

12. The method according to one of claims 10 and 11, **characterised in that** the mixture (5) comprises a dispersing agent.

13. The method according to any one of claims 10 to 12, **characterised in that** the mixture (5) comprises mineral particles absorbing water and oxygen.

14. The method according to claim 13, **characterised in that** the mineral particles are selected from clays and carbon nanotubes.

15. The method according to any one of claims 10 to 14, **characterised in that** the surface of the silicon particles (4) is cleaned with hydrofluoric acid before the main thin layer (12, 16, 17) is formed.

16. The method according to any one of claims 10 to 15, **characterised in that** debinding step of the self-supported film (2, 10, 15) is performed by heating the self-supported film at a temperature comprised between about 300°C and about 500°C.

17. The method according to any one of claims 10 to 16, **characterised in that** the sintering step is performed by heat treatment at a temperature comprised between about 1000°C and about 1300°C.

18. The method according to any one of claims 10 to 17, **characterised in that** the sintering step is performed in a hydrogen atmosphere.
